# EUROPEAN PATENT APPLICATION

(11) **EP 4 167 291 A1**
(43) Date of publication of application: **19.04.2023**
(21) Application number: 21905343.6
(22) Date of filing: 02.11.2021
(51) Int. Cl.: H01L 29/24, H01L 29/786, H01L 21/34, C23C 14/34, C23C 14/08

(54) **METAL OXIDE SEMICONDUCTOR MATERIAL, TARGET MATERIAL AND PREPARATION METHOD THEREFOR, THIN FILM TRANSISTOR AND PREPARATION METHOD THEREFOR**

(30) Priority: 18.12.2020 CN 202011511468
(71) Applicant: BOE Technology Group Co., Ltd., Beijing 100015 (CN); South China University of Technology, Guangdong 510640 (CN)
(72) Inventor: YUAN, Guangcai, Beijing 100176 (CN); LAN, Linfeng, Beijing 100176 (CN); LIU, Fengjuan, Beijing 100176 (CN); NING, Ce, Beijing 100176 (CN); HU, Hehe, Beijing 100176 (CN); WANG, Fei, Beijing 100176 (CN); PENG, Junbiao, Beijing 100176 (CN)
(74) Representative: Hoffmann Eitle
(86) International application number: PCT/CN2021/128260
(87) International publication number: WO 2022/127414

(57) **Abstract**

A metal oxide semiconductor material, comprising: a semiconductor matrix material; and at least one rare earth compound doped in the semiconductor matrix material. The general formula of each rare earth compound is represented as (M_{FD})ₐA_{b}. In the general formula (M_{FD})ₐA_{b}, M_{FD} is selected from one of rare earth elements capable of generating an f-d transition, A is selected from an element capable of causing a wavelength band of an absorption spectrum of the corresponding M_{FD} having an f-d transition to be redshifted into a visible light wavelength band range, a is the number of atoms of the element M_{FD} in the general formula (M_{FD})ₐA_{b}, and b is the number of atoms of the element A.

## Description

This application claims priority to Chinese Patent Application No. 202011511468.9, filed on December 18, 2020, which is incorporated herein by reference in its entirety.

### TECHNICAL FIELD

The present disclosure relates to the technical field of semiconductors, and in particular, to a metal oxide semiconductor material, a target material and a method for fabricating the same, a thin film transistor and a method for fabricating the same.

### BACKGROUND

Thin film transistors (TFTs) are semiconductor devices commonly used in flat panel displays. As devices for controlling and driving pixels in the flat panel displays, the TFTs affect the development of flat panel displays.

### SUMMARY

In one aspect, a metal oxide semiconductor material is provided. The metal oxide semiconductor material includes a semiconductor base material and at least one kind of rare earth compound doped in the semiconductor base material. Each kind of rare earth compound has a general formula represented as (M_{FD})ₐA_{b}. In the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}.

In some embodiments, in the general formula (M_{FD})ₐA_{b}, M_{FD} is an element selected from lanthanide metal elements other than lanthanum.

In some embodiments, in the general formula (M_{FD})ₐA_{b}, M_{FD} is an element selected from cerium, praseodymium, neodymium, promethium, samarium, terbium and dysprosium.

In some embodiments, in the general formula (M_{FD})ₐA_{b}, M_{FD} is an element selected from praseodymium and terbium.

In some embodiments, in the general formula (M_{FD})ₐA_{b}, A is an element selected from elements whose electronegativities are less than an electronegativity of oxygen.

In some embodiments, in the general formula (M_{FD})ₐA_{b}, A is an element selected from sulfur, selenium, tellurium, bromine, iodine, arsenic and boron.

In some embodiments, in each kind of rare earth compound comprised in the metal oxide semiconductor material, a minimum energy required for the element M_{FD} to undergo the f-d transition is less than 2.64 eV.

In some embodiments, in each kind of rare earth compound comprised in the metal oxide semiconductor material, the minimum energy required for the element M_{FD} to undergo the f-d transition is greater than 2.48 eV.

In some embodiments, the semiconductor base material includes at least one kind of first metal oxide and/or at least one kind of second metal oxide. Each kind of first metal oxide and each kind of second metal oxide both have a general formula M_{c}O_{d}. For each kind of first metal oxide, M in the general formula M_{c}O_{d} is an element selected from indium, zinc, gallium, tin and cadmium. For each kind of second metal oxides, M in the general formula M_{c}O_{d} is a combination of two or more elements selected from indium, zinc, gallium, tin and cadmium, c is a number of M in the general formula M_{c}O_{d}, and d is a number of oxygens in the general formula.

In some embodiments, in the general formula M_{c}O_{d}, M further includes an element or a combination of any two or more elements of lanthanide metals, scandium and yttrium.

In some embodiments, in the metal oxide semiconductor material, an elemental composition of the semiconductor base material and the at least one kind of rare earth compound is represented as ((M_{FD})ₐA_{b})_{X}(M_{c}O_{d})_{1-X}, where x is greater than or equal to 0.001 and less than or equal to 0.15.

In some embodiments, in the general formula (M_{FD})ₐA_{b}, in a case where M_{FD} is an element selected from praseodymium and terbium, x is greater than or equal to 0.01 and less than or equal to 0.1.

In some embodiments, in the general formula (M_{FD})ₐA_{b}, in a case where cerium is selected as M_{FD}, x is greater than or equal to 0.001 and less than or equal to 0.02.

In another aspect, a target material is provided. The target material includes the metal oxide semiconductor material as described above.

In some embodiments, in the general formula (M_{FD})ₐA_{b} of the metal oxide semiconductor material, A is an element selected from sulfur, selenium, tellurium, arsenic and boron.

In yet another aspect, a thin film transistor is provided. The thin film transistor includes: an active layer. A material of the active layer includes the metal oxide semiconductor material as described above.

In yet another aspect, a method for fabricating a target material is provided. The method includes:
doping a semiconductor base material with at least one kind of rare earth compound in proportion, and mixing the semiconductor base material and the at least one kind of rare earth compound evenly, a general formula of each kind of rare earth compound being represented as (M_{FD})ₐA_{b}, where in the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}; and
performing ball milling, hot pressing or slurry casting, and then sintering the evenly mixed semiconductor base material doped with the at least one kind of rare earth compound to obtain the target material.

In some embodiments, in the general formula (M_{FD})ₐA_{b}, A is an element selected from sulfur, selenium, tellurium, arsenic and boron.

In yet another aspect, a method for fabricating a thin film transistor is provided. The method includes:
forming a semiconductor film on a base substrate, a material of the semiconductor film including a semiconductor base material and at least one kind of rare earth compound doped in the semiconductor base material, a general formula of each kind of rare earth compound being represented as (M_{FD})ₐA_{b}, where in the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}; and patterning the semiconductor film to obtain an active layer of the thin film transistor.

In some embodiments, in a case where in the at least one kind of rare earth compound, A is one or more elements selected from sulfur, selenium, tellurium, arsenic and boron, forming the semiconductor film on the base substrate, includes:
providing a target material including a metal oxide semiconductor material, and forming the semiconductor film on the base substrate by a sputtering process; or
providing target materials including the at least one kind of rare earth compound and the semiconductor base material respectively, and forming the semiconductor film on the base substrate by a double-target sputtering process.

In some embodiments, in a case where in the at least one kind of rare earth compound, A is one or both of bromine and iodine, forming the semiconductor film on the base substrate, includes: forming the semiconductor film on the base substrate by a solution method.

In some embodiments, the solution method includes one of spin coating, ink jet printing, screen printing, scrape coating and imprinting.

### BRIEF DESCRIPTION OF THE DRAWINGS

In order to describe technical solutions in the present disclosure more clearly, accompanying drawings to be used in some embodiments of the present disclosure will be introduced briefly below. However, the accompanying drawings to be described below are merely accompanying drawings of some embodiments of the present disclosure, and a person having ordinary skill in the art can obtain other drawings according to these accompanying drawings. In addition, the accompanying drawings in the following description may be regarded as schematic diagrams, but are not limitations on an actual size of a product, an actual process of a method and an actual timing of a signal involved in the embodiments of the present disclosure.
FIG. 1 is a sectional structure diagram of a thin film transistor (TFT), in accordance with some embodiments;
FIG. 2 is a diagram of a pixel circuit in an active-matrix organic light-emitting diode (AMOLED) display device, in accordance with some embodiments;
FIG. 3 shows an energy band structure diagram under positive gate bias illumination stress (PBIS) and an energy band structure diagram under negative gate bias illumination stress (NBIS) that are based on photo-generated hole-electron pair theory, in accordance with some embodiments;
FIG. 4 is a flowchart of a method for fabricating a target material, in accordance with some embodiments;
FIG. 5 is a flowchart of a method of fabricating a TFT, in accordance with some embodiments;
FIG. 6 is a diagram showing transfer characteristic curves of TFTs doped with Pr₂S₃ under NBIS conditions, in accordance with some embodiments;
FIG. 7 is a diagram showing transfer characteristic curves of TFTs doped with Pr₂O₃ under NBIS conditions, in accordance with some embodiments; and
FIG. 8 is a graph showing absorption spectrums of semiconductor films respectively doped with Pr₂O₃ and Pr₂S₃, in accordance with some embodiments.

### DETAILED DESCRIPTION

Technical solutions in some embodiments of the present disclosure will be described clearly and completely below with reference to the accompanying drawings. However, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representation of the above terms does not necessarily refer to the same embodiment(s) or example(s). In addition, the specific features, structures, materials or characteristics may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, the features defined with "first" and "second" may explicitly or implicitly include one or more of the features. In the description of the embodiments of the present disclosure, the term "a plurality of / the plurality of" means two or more unless otherwise specified.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

The phrase "applicable to" or "configured to" as used herein indicates an open and inclusive expression, which does not exclude devices that are applicable to or configured to perform additional tasks or steps.

In addition, the use of the phrase "based on" is meant to be open and inclusive, since a process, step, calculation or other action that is "based on" one or more of the stated conditions or values may, in practice, be based on additional conditions or values exceeding those stated.

Exemplary embodiments are described herein with reference to sectional views and/or plan views as idealized exemplary drawings. In the accompanying drawings, thicknesses of layers and areas of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown in a rectangular shape generally has a feature of being curved. Therefore, the regions shown in the accompanying drawings are schematic in nature, and their shapes are not intended to show actual shapes of the region in a device, and are not intended to limit the scope of the exemplary embodiments.

Some embodiments of the present disclosure provide a display device. The display device includes a display panel and driving circuits, such as pixel driving circuits and a gate driving circuit, disposed on the display panel.

Thin film transistors (TFTs) are important components for constituting the pixel driving circuits, the gate driving circuit, etc. During a power-on process, by controlling the TFTs to be turned on or turned off, the pixel driving circuits and the gate driving circuit may be controlled to drive the display panel to display images.

The display device may be one of a liquid crystal display (LCD) device, an organic light-emitting diode (OLED) display device, a quantum dot light-emitting diode (QLED) display device, a micro light-emitting diode (micro LED) display device, a mini light-emitting diode (mini LED) display device.

The display device may be a mobile phone, a tablet computer, a notebook computer, a personal digital assistant (PDA), a vehicle-mounted computer, a laptop computer, or a digital camera.

Depending on a material of an active layer, TFTs mainly include amorphous silicon (e.g., hydrogenated amorphous silicon (a-Si: H)) TFTs, low temperature polysilicon (LTPS) TFTs, metal oxide TFTs and organic TFTs, etc.

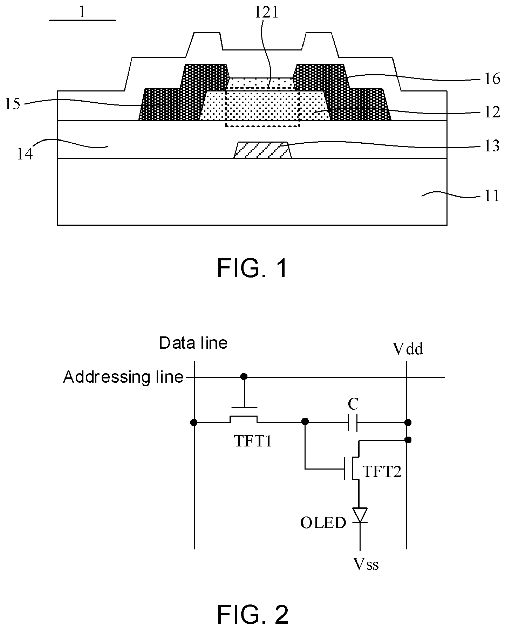

The metal oxide semiconductor TFTs attract a lot of attention due to advantages such as large band gap, high carrier mobility and low process temperature of metal oxides, and good device uniformity. However, the metal oxide semiconductor TFTs still have some problems to be solved. For example, it is difficult for metal oxide semiconductors, which are usually n-type conductive, to obtain p-type conductivity characteristics, so an application thereof in complementary circuits is limited. In addition, negative gate bias stress (NBS) stability of the metal oxide semiconductors under illumination is insufficient. In particular, TFTs 1, which serve as components of the display panel, are inevitably irradiated by light during application in the display field. For example, as shown in FIG. 1, in LCD, a channel 121 of a TFT 1 will be irradiated by backlight; and in OLED display, the channel 121 of the TFT 1 will be affected by light emitted by an OLED. Light emitted by both a backlight source and a self-luminescence device is in a visible light range in which blue light has the largest photon energy. However, metal oxide semiconductor materials (e.g., indium zinc oxide (IZO), indium gallium zinc oxide (IGZO)) are particularly sensitive to blue light, because blue light will cause ionization of oxygen vacancies in the metal oxide semiconductor materials, and then electrons are released into a conduction band to participate in conduction, which results in a negative drift of a threshold voltage to cause a deterioration of display images.

Here, as shown in FIG. 2, considering an example where a pixel driving circuit in an active-matrix organic light-emitting diode (AMOLED) display includes at least two TFTs respectively referred to as an addressing transistor TFT 1 and a driving transistor TFT 2, since most metal oxide semiconductor TFTs only exhibit n-channel characteristics, the metal oxide semiconductor TFTs are turned on under a positive gate voltage, and turned off under a negative gate voltage (when a carrier concentration in a metal oxide semiconductor is large, a normally open state appears, which means that the negative gate voltage is needed to realize complete turn-off). The addressing transistor TFT 1 is only turned on once in each scanning cycle, and is kept turned off for rest of time. Thus, stability of the addressing transistor TFT 1 under NBS is extremely important. A source of the driving transistor TFT 2 is directly connected to an OLED. Whenever the OLED emits light, there must be a certain amount of current passing through the source and a drain of the driving transistor TFT 2. Therefore, the driving transistor TFT 2 is basically kept in a turn-on state, and stability of the driving transistor TFT 2 under a positive gate bias stress (PBS) is important. However, the metal oxide semiconductor TFTs show a threshold voltage (Vₜₕ) shift phenomenon under a gate bias stress.

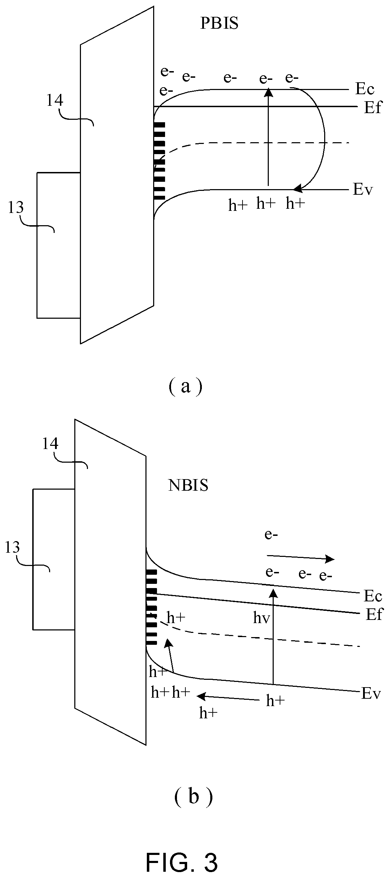

Hereinafter, cases that cause the threshold voltage shift will be described in detail. As shown in FIG. 3, considering a trapping model of photo-generated holes as a basis, under illumination, electron-hole pairs are generated in a metal oxide semiconductor layer (i.e., an active layer 12). In this case, as shown in (a) of FIG. 3, if a PBS is applied to a gate 13, a large number of electrons will be generated at an interface between the active layer 12 and a gate insulating layer 14 to shield an electric field. Thus, an induced electric field in the active layer 12 is weakened, and then the photo-generated electron-hole pairs will not move. As soon as the stress is removed, the electrons will combine with holes immediately. Thus, a threshold voltage shift of the TFT under a positive gate bias illumination stress (PBIS) is not obvious. As shown in (b) of FIG. 3, if a NBS is applied to the gate 13, since the metal oxide semiconductor is of n-type conductivity, the active layer 12 is in a depleted state when the NBS is applied to the gate 13. In this case, a voltage drop is generated between an upper surface and a lower surface of the active layer 12. Thus, holes move towards an interface between the active layer 12 and the gate insulating layer 14, and electrons move in an opposite direction. When moving to the interface between the active layer 12 and the gate insulating layer 14, the holes will be trapped or enter the gate insulating layer 14. Consequently, the electrons cannot combine with the holes after the stress is removed, thereby causing a negative shift of the threshold voltage.

Therefore, it is particularly important to improve threshold voltage stability of the metal oxide semiconductor TFTs under negative gate bias illumination stress (NBIS).

In order to solve the problems, in related art, the active layer 12 of the TFT 1 is usually shielded from light by a black matrix, so as to improve photostability. However, this method cannot solve a problem that light enters the oxide semiconductor layer through diffraction, and an improvement in stability under a long-term illumination condition is limited. In addition, an added light-shielding process complicates a fabrication, which causes manufacturing costs to be increased.

In light of this, some embodiments provide a metal oxide semiconductor material, which includes a semiconductor base material and at least one kind of rare earth compound doped in the semiconductor base material, and each kind of rare earth compound has a general formula represented as (M_{FD})ₐA_{b}. In the general formula (M_{FD})ₐA_{b}, M_{FD} is an element selected from rare earth elements capable of undergoing f-d transition and/or charge transfer transition. Here, FD is only a subscript used to distinguish this M_{FD} from M mentioned below, but not a limitation on a number of M. That is, FD is different from meanings of a and b in the general formula. In the description below, in M_{FD}, FD serves as the subscript of M, and FD and M as a whole are used to represent a rare earth element capable of undergoing the f-d transition. In other words, FD is an abbreviation for the f-d transition in embodiments of the present application. A is selected from elements capable of stretching a wavelength range of an absorption spectrum of M_{FD} capable of undergoing the f-d transition and/or the charge transfer transition towards red light (i.e., red-shifting) into a visible light range, a is a number of the element M_{FD} in the general formula (M_{FD})ₐA_{b}. b is a number of the element A in the general formula (M_{FD})ₐA_{b}.

The semiconductor base material may be a p-type metal oxide semiconductor material or an n-type metal oxide semiconductor material, which is not specifically limited here. In a case where the semiconductor base material is a p-type metal oxide semiconductor material, the p-type metal oxide semiconductor material may include copper oxide (CuO), tin oxide (SnO), etc. In a case where the semiconductor base material is an n-type metal oxide semiconductor material, the n-type metal oxide semiconductor material may include, for example, indium tin oxide (ITO), indium gallium zinc oxide (IGZO), etc.

In some embodiments, the semiconductor base material may include at least one kind of first metal oxide and/or at least one kind of second metal oxide. A general formula for each kind of first metal oxide and a general formula for each kind of second metal oxide are both represented as M_{c}O_{d}. For each kind of first metal oxide, M in the general formula is an element selected from indium, zinc, gallium, tin and cadmium. For each kind of second metal oxide, M in the general formula is a combination of two or more elements selected from indium, zinc, gallium, tin and cadmium, c is a number of M in the general formula. d is a number of oxygens in the general formula.

According to that, M in each kind of first metal oxide is an element selected from indium, zinc, gallium, tin and cadmium, and M in each kind of second metal oxide is selected from combination of two or more elements selected from indium, zinc, gallium, tin and cadmium, it will be known that, the first metal oxide is a binary oxide, and the second metal oxide may be a ternary oxides, a quaternary oxide, or the like.

For example, in cases where indium, zinc, gallium, tin and cadmium are each selected as M, first metal oxides may be represented as In₂O₃, ZnO, Ga₂O₃, SnO, SnO₂ and CdO, respectively. In these cases, c and d are both positive integers. For In₂O₃, c is equal to 2, and d is equal to 3. For ZnO, c is equal to 1 and d is equal to 1. For Ga₂O₃, c is equal to 2 and d is equal to 3. For SnO, c is equal to 1 and d is equal to 1. For SnO₂, c is equal to 1 and d is equal to 2. For CdO, c is equal to 1 and d is equal to 1.

However, it will be noted that, in practical applications, in light of defects such as vacancies and gaps existing in a film, c and d may be decimals. Considering In₂O₃ as an example, a ratio of a number of atoms In to a number of atoms O may deviate slightly from 2 : 3. Considering PrB₆ as an example, a ratio of a number of atoms Pr to a number of atoms B may deviate slightly from 1 : 6. For a semiconductor base material includes only a tin oxide, according to that tin oxides may include SnO and SnO₂, it will be known that, a ratio of a number of atoms Sn to a number of atoms O in the semiconductor base material may be less than 1. For example, the ratio is 0.95. In this case, the tin oxide is SnO.

Depending on a different combination selected as M, the second metal oxide may be indium tin oxide (ITO), indium zinc oxide (IZO), indium gallium zinc oxide (IGZO) or indium tin zinc oxide (ITZO). ITO and IZO are ternary oxides. IGZO and ITZO are quaternary oxides. For these oxides, c may be equal to 1, and d may be equal to 1. Similar to the description above, since there are defects such as vacancies and gaps in a metal oxide semiconductor film, c and d may also be decimals.

Other than SnO, the metal oxides above may all be n-type metal oxide semiconductor materials. The oxide SnO may achieve p-type conductivity only under a strict single crystal condition. Therefore, in some embodiments, in a case where tin is selected as M in the general formula, c may be equal to 1, and d may be equal to 2. That is, a tin oxide is SnO₂. In this case, the metal oxide semiconductor material is an n-type metal oxide semiconductor material, and has high electron mobility in an amorphous state. Here, similar to the metal oxide semiconductor film where the defects such as vacancies and gaps exist, c and d may also be decimals.

As for the semiconductor base material, it is found through studies on photostability of the metal oxide semiconductor TFTs that, the ionization of oxygen vacancies is a reason for continuous photoconductivity. Photo-generated hole carriers are confined to the oxygen vacancies, and the oxygen vacancies become singly ionized Vo⁺ or doubly ionized Vo²⁺ under illumination, which in turn contributes free electrons related to continuous photoconductivity. Therefore, it is expected to improve the photostability of the metal oxide semiconductor TFT by reducing concentrations of oxygen vacancies within the channel and at the interface. Therefore, in order to suppress oxygen vacancies, in some embodiments, M in the general formula M_{c}O_{d} further includes one of or a combination of any two or more of lanthanide metals, scandium and yttrium.

In this case, according to that, M in the general formula M_{c}O_{d} is an element selected from indium, zinc, gallium, tin and cadmium, and M further includes an element or a combination of any two or more of lanthanide metals, scandium and yttrium, it may be known that, M may be a combination of any two or more elements selected from of indium, zinc, gallium, tin, cadmium, lanthanide metals, scandium and yttrium elements. That is, M_{c}O_{d} is a polynary oxide.

For example, in a case where M does not include one or a combination of any two or more of lanthanide metals, scandium and yttrium, indium may be selected as M. In this case, c may be equal to 2, and d may be equal to 3. That is, M_{c}O_{d} is In₂O₃. In a case where M includes one or a combination of any two or more of lanthanide metals, scandium and yttrium, a combination of indium and scandium may be selected as M. In this case, c may be equal to 1, and d may be equal to 1. That is, M_{c}O_{d} may be represented as ScInO.

According to that, M in the general formula M_{c}O_{d} is a combination of any two or more elements selected from indium, zinc, gallium, tin and cadmium, and M further includes one or a combination of any two or more of lanthanide metals, scandium and yttrium, it may be known that, M may be a combination of any three or more elements selected from of indium, zinc, gallium, tin, cadmium, lanthanide metals, scandium and yttrium. In this case, M_{c}O_{d} is also a polynary oxide.

For example, in a case where M does not include one or a combination of any two or more of lanthanide metals, scandium and yttrium, indium and cadmium may be selected as M. In this case, c and d may both be equal to 1. That is, M_{c}O_{d} is InCdO. In a case where M includes one or a combination of any two or more of lanthanide metals, scandium and yttrium, a combination of indium, cadmium and scandium may be selected as M. In this case, both c and d may also be equal to 1. That is, M_{c}O_{d} may be represented as ScCdlnO.

According to that, the general formula of each kind of rare earth compound is represented as (M_{FD})ₐA_{b}, in the general formula (M_{FD})ₐA_{b}, M_{FD} is an element selected from the rare earth elements capable of undergoing the f-d transition and/or the charge transfer transition, A is selected from elements capable of stretching the wavelength range of the absorption spectrum of M_{FD} capable of undergoing the f-d transition and/or the charge transfer transition towards red light into the visible light range, a is the number of the element M_{FD} in the general formula (M_{FD})ₐA_{b}, and b is the number of the element A in the general formula (M_{FD})ₐA_{b}, it can be seen that, M_{FD} in the general formula (M_{FD})ₐA_{b} may be an element selected from lanthanide metals other than lanthanum. A wavelength range of the visible light in an electromagnetic spectrum is about from 880 nm to 380 nm, and the light with the largest photon energy in the range of visible light is blue light. The semiconductor base materials (e.g., indium zinc oxide (IZO), indium gallium zinc oxide (IGZO)) are particularly sensitive to blue light. Theoretically, ions with an f-electron and a non-full d-level orbital (corresponding to elements from cerium to platinum in the periodic table of elements, i.e., all elements from numbers 58 to 78) are all capable of undergoing the f-d transition. However, energies (E_{fd}) required for the f-d transition of a free ion are usually greater than 6 eV, absorbed light is in a deep ultraviolet region, and blue light cannot be absorbed. Especially, for elements such as hafnium, tantalum and tungsten other than the lanthanide metals, since f-electrons are full, E_{fd} thereof is very large, and it is impossible to stretching a wavelength range of an absorption spectrum of f-d transition towards red light into the visible light range no matter what method is used. In addition, since having no f-electrons, the element lanthanum cannot undergo the f-d transition. However, for rare earth elements cerium, praseodymium and terbium, similar to most organics, under irradiation of electromagnetic waves, the charge transfer transition may occur thereto. That is, electrons transition from an electron orbital of a ligand (referring to an anion of A) to an electron orbital of a metal ion. Thus, a charge transfer absorption spectrum is generated, and blue light may be absorbed. For example, the charge transfer absorption spectrum may be an absorption spectrum of a trivalent ion being oxidized to a tetravalent ion.

Here, it will be noted that, for a case where the rare earth element is an element selected from cerium, praseodymium and terbium, an absorption spectrum of an ion of the rare earth element undergoing the f-d transition may overlap with an absorption spectrum of the ion of the rare earth element undergoing the charge transfer transition.

Table 1 below shows values of E_{fd} of trivalent ions of some elements in the lanthanides.

**Table 1**

| Ion | Cerium Ce | Praseodymium Pr | Neodymium Nd | Promethium Pm | Samarium Sm | Europium Eu | Gadolinium Gd |
|---|---|---|---|---|---|---|---|
| E_{fd} (eV) | 6.1 | 7.6 | 8.9 | 9.3 | 9.4 | 10.5 | 11.8 |

| Ion | Terbium Tb | Dysprosium Dy | Holmium Ho | Erbium Er | Thulium Tm | Ytterbium Yb | Lutecium Lu |
|---|---|---|---|---|---|---|---|
| E_{fd} (eV) | 6.9 | 8.5 | 9.6 | 9.4 | 9.4 | 10.6 | 12.0 |

In some embodiments, in the general formula (M_{FD})ₐA_{b}, M_{FD} is an element selected from cerium, praseodymium, neodymium, promethium, samarium, terbium and dysprosium. Ions of these elements have relatively low E_{fd}. M_{FD} may easily absorb blue light by selecting an anionic environment. Since d-electrons in the ions of these elements have a short lifespan and a strong temperature quenching effect, the absorbed blue light may be converted into a non-radiative form, thereby avoiding the negative drift of the threshold voltage due to an increased conductance caused by the ionization of oxygen vacancies under blue light in the backlight or the self-luminescence device. In addition, since the rare earth elements cerium, praseodymium and terbium are capable of undergoing the charge transfer transition, in a case where the anion environment is selected, energies required for the charge transfer transition of the rare earth elements cerium, praseodymium and terbium may be adjusted by changing electron affinity of anions, i.e., changing reducing ability of the anions. In this way, M_{FD} may also absorb blue light. In addition, it is found through researches on the photostability of metal oxide semiconductor TFTs that, similar to the above case where M further includes one or a combination of any two or more of lanthanide metals, scandium and yttrium, due to an addition of these rare earth elements, it may also be possible to suppress oxygen vacancies to reduce the concentrations of oxygen vacancies within the channel and at the interface, which improves the photostability of the metal oxide semiconductor TFTs.

Based on structural features of the TFT 1, the metal oxide semiconductor material may be formed in a channel region of the active layer 12, or may be formed as a light-shielding material in a region of the active layer 12 that needs to be shielded from light. For example, in a LCD display panel, in order to prevent light emitted by the backlight source from affecting the active layer 12, a light-shielding layer including the metal oxide semiconductor material may be formed only on a surface of the active layer 12 proximate to a base substrate 11, remaining portions of the active layer 12 may be of a metal oxide semiconductor material that is not doped with (M_{FD})ₐA_{b}.

Of course, metal oxide semiconductor materials at all portions of the active layer 12 may be the metal oxide semiconductor material doped with (M_{FD})ₐA_{b}. In this case, different doping types or same doping type of metal oxide semiconductor materials with different doping amounts may be selected for different portions. Here, a location of the metal oxide semiconductor material doped with (M_{FD})ₐA_{b} in the active layer 12 and a doping ratio of (M_{FD})ₐA_{b} in the metal oxide semiconductor material are not specifically limited.

In some embodiments, in the general formula (M_{FD})ₐA_{b}, M_{FD} is an element selected from praseodymium and terbium. E_{fd} of ions of the two elements are both greater than E_{fd} of ions of neodymium, promethium, samarium and dysprosium, and it is easier for the two elements to absorb blue light by setting an anion environment. Although cerium has the lowest E_{fd}, cerium is very active, so that an electron trap is easily generated, which affects electron transport. Therefore, in a case where cerium is selected as M_{FD}, a doping with (M_{FD})ₐA_{b} goes against an improvement of carrier mobility.

In some embodiments, in the general formula (M_{FD})ₐA_{b}, A is an element selected from elements whose electronegativity is less than an electronegativity of oxygen.

Since oxygen has a large electronegativity (about 3.44), an oxide of M_{FD} are highly ionic, and an interaction between M_{FD} and oxygen is weak. Thus, an energy level of d orbital of the oxide of M_{FD} suffers slight splitting of a crystal field, such that E_{fd} of the ion of M_{FD} is still large, and absorbed light is in an ultraviolet region. In these embodiments, by selecting an element with less electronegativity than oxygen, a degree of covalency between M_{FD} and A may be increased. Thus, the energy level of d orbital of the ion of M_{FD} will be split greatly due to a relatively large nephelauxetic effect. Therefore, an energy level difference between an f configuration and a d configuration is reduced significantly, and then E_{fd} is reduced greatly, which an absorption spectrum of f-d transition of the ions is stretched towards red light, and realizes an absorption of blue light.

Under same test conditions, electronegativities of oxygen, fluorine, chlorine, nitrogen, bromine, iodine, sulfur, selenium, tellurium, phosphorus, arsenic and boron are as shown in Table 2 below.

**Table 2**

| Element | Fluorine F | Oxygen O | Chlorine Cl | Nitrogen N | Bromine Br | Iodine I |
|---|---|---|---|---|---|---|
| Electronegativity | 3.98 | 3.44 | 3.16 | 3.04 | 2.96 | 2.66 |

| Ion | Selenium Se | Tellurium Te | Phosphorus P | Arsenic As | Boron B | Sulfur S |
|---|---|---|---|---|---|---|
| Electronegativity | 2.55 | 2.10 | 2.19 | 2.18 | 2.04 | 2.58 |

As may be seen from Table 2 that, in the general formula (M_{FD})ₐA_{b}, A may be an element selected from chlorine, nitrogen, bromine, iodine, sulfur, selenium, tellurium, phosphorus, arsenic and boron.

In some embodiments, in the general formula (M_{FD})ₐA_{b}, A may be an element selected from sulfur, selenium, tellurium, bromine, iodine, phosphorus, arsenic and boron. Electronegativities of these elements are each less than the electronegativity of oxygen by more than 0.5, and may generate a significant nephelauxetic effect.

It will be noted that, in the elements of sulfur, selenium, tellurium, bromine, iodine, phosphorus, arsenic and boron, boron has the lowest electronegativity, and hexaborides of the rare earth elements are very stable; and the ion of M_{FD} exists in a plurality of valence states, which is beneficial to reduce E_{fd} of the ion of M_{FD}. Therefore, optionally, boron may be selected as A in the general formula (M_{FD})ₐA_{b}.

A doping amount of the at least one kind of rare earth compound described above is not specifically limited. In practical application, since the f-d transition of the ions of M_{FD} in the rare earth compounds is an allowed transition, and an intensity thereof is 10⁶ times greater than an intensity of the f-f transition, a large amount of blue light may be absorbed by a doping with a small amount of the rare earth compound. In addition, the smallamount doping will not cause a large number of defects in the metal oxide semiconductor material, and then has little impact on the electron mobility.

In addition, depending on energy required for the f-d transition of the ions of M_{FD} of the rare earth compounds and an influence of the ions of M_{FD} on the electron mobility, for different ions of M_{FD}, doping amounts may be different.

In addition, due to the above doping, there is no need to widen a band gap of the semiconductor base material in the present disclosure, so that In₂O₃ or SnO₂ with relatively a narrow band gap may be selected as the semiconductor base material. This is because 5s orbitals, adjacent to each other, of In may overlap to form an electron channel, and 5s orbitals, adjacent to each other, of Sn may overlap to form an electron channel, it may be possible to ensure a high electron mobility of the metal oxide semiconductor material.

In some embodiments, in the metal oxide semiconductor material, an elemental composition of the semiconductor base material and the at least one kind of rare earth compound may be represented as ((M_{FD})ₐA_{b})ₓ(M_{c}O_{d})₁₋ₓ, where x is greater than or equal to 0.001 and less than or equal to 0.15. That is, a mole proportion of (M_{FD})ₐA_{b} in the semiconductor base material and the at least one kind of rare earth compound is greater than or equal to 0.1% and less than or equal to 15%.

In some other embodiments, x is greater than or equal to 0.005 and less than or equal to 0.1. That is, the mole proportion of (M_{FD})ₐA_{b} in the semiconductor base material and the at least one kind of rare earth compound is greater than or equal to 0.5% and less than or equal to 10%.

In some embodiments, in the general formula (M_{FD})ₐA_{b}, in a case where M_{FD} is an element selected from praseodymium and terbium, x is greater than or equal to 0.01 and less than or equal to 0.1. That is, the mole proportion of (M_{FD})ₐA_{b} in the semiconductor base material and the at least one kind of rare earth compound is greater than or equal to 1% and less than or equal to 10%. With this molar proportion, most of blue light may be absorbed.

Here, it will be noted that, since E_{fd} of terbium is lower than E_{fd} of praseodymium, in some embodiments, Terbium is selected as M_{FD} in the at least one kind of rare earth compound.

In some embodiments, in the general formula (M_{FD})ₐA_{b}, a value of x in a case where cerium is selected as M_{FD} is less than a value of x in a case where M_{FD} is selected from elements other than cerium. This is because a nephelauxetic effect of an ion of cerium is very significant, it may be possible to avoid an influence on the mobility due to an excessive doping with cerium by controlling a doping with cerium at a small amount.

In some embodiments, in the general formula (M_{FD})ₐA_{b}, in the case where cerium is selected as M_{FD}, x is greater than or equal to 0.001 and less than or equal to 0.02. That is, the mole proportion of (M_{FD})ₐA_{b} in the semiconductor base material and the at least one kind of rare earth compound is greater than or equal to 0.1% and less than or equal to 2%. With this mole proportion, a NBIS stability may be effectively improved; and the influence of the doping on the mobility may be minimized.

In some embodiments, the metal oxide semiconductor material further includes a compound of rhenium. This is because, an ion of rhenium has a large radius, and the rhenium compound naturally has a high electron mobility, so that rhenium is capable of adjusting the electron mobility of the metal oxide semiconductor material.

An anion in the compound of rhenium may be one of oxygen and A. In a case where the anion in the compound of rhenium is oxygen, the compound of rhenium is a rhenium oxide. In a case where the anion in the rhenium compound is A, the compound of rhenium may be represented as ReₑA_{f}, where e is a number of the element Re in the compound ReₑA_{f}, and f is a number of A in the compound ReₑAf.

In some embodiments, in the metal oxide semiconductor material, a mole proportion of the compound of rhenium in the compound of rhenium and the semiconductor base material is greater than or equal to 0.02 and less than or equal to 0.15.

For example, considering an example where the compound of rhenium is ReₑA_{f}, an elemental composition of the compound of rhenium and the semiconductor base material may be represented as: (ReₑA_{f})_{y}(M_{c}O_{d})_{1-y}, where y is greater than or equal to 0.02 and less than or equal to 0.15.

Here, it will be noted that, similar to c and d above, a and b, as well as e and f, may also be positive integers or decimals. For specific reasons, reference may be made to the above description of c and d.

Here, considering an example where praseodymium is selected as M_{FD} in the general formula (M_{FD})ₐA_{b}, and bromine is selected as A in the general formula (M_{FD})ₐA_{b}, a may be equal to 1, and b may be equal to 3; or a may be equal to 1, and b may be equal to 2.95.

In some embodiments, in each kind of rare earth compound included in the metal oxide semiconductor material, a minimum energy required for the element M_{FD} to undergo the f-d transition and/or the charge transfer transition is less than 2.64 eV.

In these embodiments, by limiting the minimum energy required for the element M_{FD} in each kind of rare earth compound included in the metal oxide semiconductor material to undergo the f-d transition and/or the charge transfer transition in the range of less than 2.64 eV, since such a minimum energy corresponds to light with wavelengths greater than 470 nm, most of the blue light from the backlight source and the self-luminescence device may be absorbed.

Here, E_{fd} of the ions of M_{FD} in Table 1 are different, and an ion of M_{FD} having an appropriate E_{fd} and an ion of A may be selected according to such a minimum energy range above. For example, in a case where A is selected from sulfur, selenium, tellurium, phosphorus, arsenic and boron, other than praseodymium, terbium and cerium whose E_{fd} are relatively low, minimum energies required for remaining elements to undergo the f-d transition and/or the charge transfer transition may all be limited in the range of less than 2.64 eV.

Considering that light emitted by the backlight source and the self-luminescence device further include blue light with wavelengths from 470 nm to 500 nm, optionally, in each kind of rare earth compound included in the metal oxide semiconductor material, the minimum energy required for the element M_{FD} to undergo the f-d transition and/or the charge transfer transition is greater than 2.48 eV.

Since the minimum energy required for the element M_{FD} to undergo the f-d transition and/or the charge transfer transition is limited in a range of greater than 2.48 eV, and such a minimum energy corresponds to light with a wavelength less than 500 nm, the metal oxide semiconductor materials are not sensitive to light with a wavelength greater than 500 nm. Therefore, stability of NBIS may be greatly improved by simply absorbing the light with the wavelength less than 500 nm.

Here, in a case where M_{FD} is selected from praseodymium and terbium, the minimum energy required for the ion of M_{FD} to undergo the f-d transition may be kept greater than 2.48 eV by selecting A from sulfur, selenium, tellurium, phosphorus, arsenic and boron.

Some embodiments of the present disclosure provide an application of the metal oxide semiconductor material in semiconductor devices. The metal oxide semiconductor material includes the semiconductor base material, and the at least one kind of rare earth compound doped in the semiconductor base material. Each kind of rare earth compound is represented as the general formula (M_{FD})ₐA_{b}. In the general formula (M_{FD})ₐA_{b}, M_{FD} is an element selected from the rare earth elements capable of undergoing the f-d transition and/or the charge transfer transition, A is selected from the elements capable of stretching the wavelength range of the absorption spectrum of M_{FD} capable of undergoing the f-d transition and/or the charge transfer transition towards red light into the visible light range, a is the number of the element M_{FD} in the general formula (M_{FD})ₐA_{b}, and b is the number of the element A in the general formula (M_{FD})ₐA_{b}.

Here, for the semiconductor base material and the rare earth compound (M_{FD})ₐA_{b} in the metal oxide semiconductor material, reference may be made to the above description for the semiconductor base material and the rare earth compound (M_{FD})ₐA_{b}, which will not be repeated here.

In some embodiments, the semiconductor devices may include an integrated circuit, a photodetector, a semiconductor light-emitting diode, a semiconductor laser, a photocell, etc.

Some embodiments of the present disclosure provide a target material. The target material includes the metal oxide semiconductor material. The metal oxide semiconductor material includes the semiconductor base material and the at least one kind of rare earth compound doped in the semiconductor base material. The general formula of each kind of rare earth compound is represented as (M_{FD})ₐA_{b}. In the general formula (M_{FD})ₐA_{b}, M_{FD} is an element selected from the rare earth elements capable of undergoing the f-d transition and/or the charge transfer transition, A is selected from the elements capable of stretching the wavelength range of the absorption spectrum of M_{FD} capable of undergoing the f-d transition and/or the charge transfer transition towards red light into the visible light range, a is the number of the element M_{FD} in the general formula (M_{FD})ₐA_{b}, and b is the number of the element A in the general formula (M_{FD})ₐA_{b}.

Here, for the semiconductor base material and the rare earth compound (M_{FD})ₐA_{b} in the metal oxide semiconductor material, reference may be made to the above description for the semiconductor base material and the rare earth compound (M_{FD})ₐA_{b}, which will not be repeated here.

Considering that the target needs experience a high temperature above 1000 °C during sintering, it can be seen that, in some embodiments, A in the general formula (M_{FD})ₐA_{b} is an element selected from sulfur, selenium, tellurium, arsenic and boron. This is because, in a case where A is selected from sulfur, selenium, tellurium, arsenic and boron, it may be possible to ensure better stability of the target during manufacture.

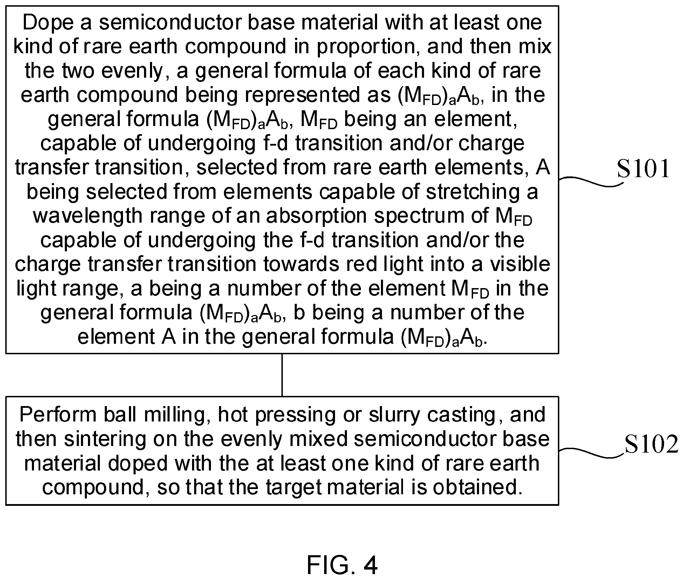

Some embodiments of the present disclosure provide a method for fabricating a target material. As shown in FIG. 4, the method includes the following steps.

In a step S101, a semiconductor base material is doped with at least one kind of rare earth compound in proportion, and then the two are mixed evenly. A general formula of each kind of rare earth compound is represented as (M_{FD})ₐA_{b}. In the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}.

Here, for the semiconductor base material and the rare earth compound (M_{FD})ₐA_{b}, specific reference may be made to the above description for the semiconductor base material and the rare earth compound (M_{FD})ₐA_{b}, which will not be repeated here.

In a step S102, ball milling, hot pressing or slurry casting, and then sintering are performed on the evenly mixed semiconductor base material doped with the at least one kind of rare earth compound, so that the target material is obtained.

In some embodiments, in the general formula (M_{FD})ₐA_{b}, A is an element selected from sulfur, selenium, tellurium, arsenic and boron. Considering that sintering is performed at a temperature above 1000 °C, it can be known that, by selecting one of sulfur, selenium, tellurium, arsenic and boron as an anion, it may be possible to enhance the stability of (M_{FD})ₐA_{b} during the high temperature sintering process.

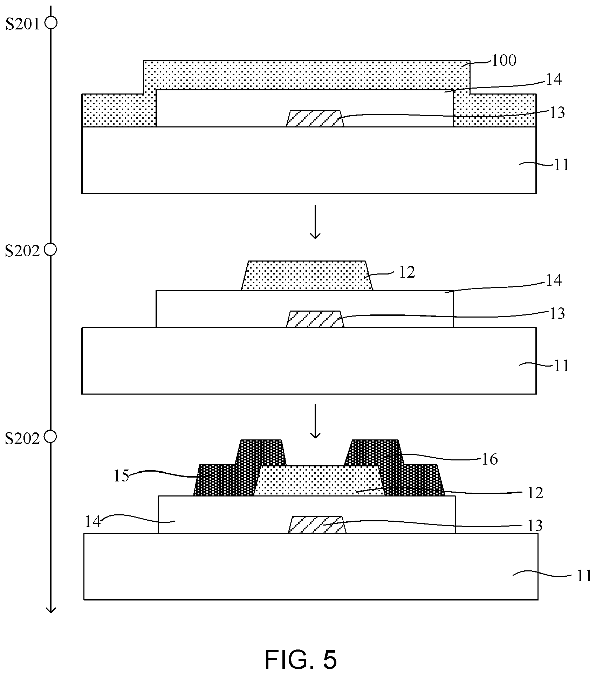

Some embodiments of the present disclosure provide a method for fabricating a TFT. As shown in FIG. 5, the method includes the following steps.

In a step S201, a semiconductor film 100 is formed on a base substrate 11. A material of the semiconductor film 100 includes a semiconductor base material and at least one kind of rare earth compound doped in the semiconductor base material. A general formula of each kind of rare earth compound is represented as (M_{FD})ₐA_{b}, where in the general formula (M_{FD})ₐA_{b}, M_{FD} is an element, capable of undergoing f-d transition and/or charge transfer transition, selected from rare earth elements, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}.

Here, considering an example where the TFT 1 is a bottom-gate TFT, before the semiconductor film 100 is formed on the base substrate 11, the method may further include: forming a gate 13 and a gate insulating layer 14 on the base substrate 11. The gate 13 may be obtained by patterning a metal film formed by depositing or sputtering. The gate insulating layer 14 may be obtained through patterning after spin coating, drop coating, printing, anodizing, thermal oxidation, physical vapor deposition or chemical vapor deposition. A thickness of the gate 13 may be from 100 nm to 500 nm, inclusive. A thickness of the gate insulating layer 14 may be from 100 nm to 1000 nm, inclusive.

Here, for the semiconductor base material and the rare earth compound (M_{FD})ₐA_{b}, specific reference may also be made to the above description for the semiconductor base material and the rare earth compound (M_{FD})ₐA_{b} in the metal oxide semiconductor material, which will not be repeated here.

The semiconductor film 100 may be formed by deposition or solution method, which is not specifically limited here. The deposition includes but is not limited to sputtering, pulsed laser deposition, atomic layer deposition, etc. The solution method includes but is not limited to spin coating, inkjet printing, screen printing, scrape coating and imprinting.

In some embodiments, in a case where in the at least one kind of rare earth compound, A is one or more elements selected from sulfur, selenium, tellurium, arsenic and boron, forming the semiconductor film 100 on the base substrate 11 includes:
providing a target material including a metal oxide semiconductor material;
the target material being formed by the method for fabricating the target material described above; and
forming the semiconductor film 100 on the base substrate 11 by a sputtering process;
or providing target materials respectively including the at least one kind of rare earth compound and the semiconductor base material; and
forming the semiconductor film 100 on the base substrate 11 by a double-target sputtering process.

In these embodiments, in a case where there is one kind of rare earth compound, M_{FD} may be an element selected from cerium, praseodymium, neodymium, promethium, samarium, terbium and dysprosium, and A may be an element selected from sulfur, selenium, tellurium, arsenic and boron. In this case, for example, the rare earth compound may be Pr₂S₃. In a case where there are a plurality of kinds of rare earth compounds, M_{FD} may be one or more elements selected from cerium, praseodymium, neodymium, promethium, samarium, terbium and dysprosium, and A may be one or more elements selected from sulfur, selenium, tellurium, arsenic and boron. In this case, for example, the at least one kind of rare earth compound may include Pr₂S₃ and Tb₂S₃. This case is a case where M_{FD} is more than one selected from cerium, praseodymium, neodymium, promethium, samarium, terbium and dysprosium, and A is one selected from sulfur, selenium, tellurium, arsenic and boron. For another example, the at least one kind of rare earth compound may include Pr₂S₃ and Tb₂Te₃. This case is a case where M_{FD} is more than one selected from cerium, praseodymium, neodymium, promethium, samarium, terbium and dysprosium, and A is more than one selected from sulfur, selenium, tellurium, arsenic and boron are selected as A.

In some embodiments, in a case wherein the at least one kind of rare earth compound, A is one or both selected from bromine and iodine, forming the semiconductor film 100 on the base substrate 11 includes:
forming the semiconductor film 100 on the base substrate 11 by a solution method.

A solution preparation method used in the solution method may be a dispersion method. In the dispersion method, nano-powder of the rare earth compounds and nano-powder of the semiconductor base material may be dispersed in a solvent to form a suspension. Then, a liquid film of the suspension is formed on the base substrate 11 by spin coating, ink jet printing, screen printing, scrape coating or imprinting, and then the solvent is removed, so that the semiconductor film 100 is obtained.

After the semiconductor film 100 is formed on the base substrate 11, the method may further include: annealing the semiconductor film 100 at a temperature from 200 °C to 500 °C, inclusive. After annealing, a thickness of the semiconductor film 100 may be from 5 nm to 80 nm, inclusive.

Here, it will be noted that, since the annealing step is performed after the semiconductor film 100 is formed, in order to improve a dispersion effect of the semiconductor base material, optionally, a precursor of the semiconductor base material may be selected as the semiconductor base material in preparation.

Different from the semiconductor base material, in order to prevent an oxide of a rare earth element from being generated after annealing, (M_{FD})ₐA_{b} may be directly selected as the rare earth compound in preparation.

In these embodiments, in order to improve dispersion uniformity of the rare earth compound, in (M_{FD})ₐA_{b}, A may be one or both selected from bromine and iodine, so that a solubility of the rare earth compound in the solvent may be improved. In addition, by a direct application of (M_{FD})ₐA_{b}, it may be possible to avoid a decomposition, through which an oxide of the rare earth element is generated, in a subsequent annealing process.

For example, in a case where PrBr₃ is selected as the rare earth compound, and In₂O₃ is selected as the semiconductor base material. PrBr₃ and a precursor In(NO)₃ of In₂O₃ may be dissolved in deionized water, and a mole proportion of PrBr₃ and In(NO)₃ may be adjusted; and then a semiconductor film is formed by spin coating, annealing and other processes. During the annealing process, In(NO)₃ is decomposed to generate In₂O₃, while PrBr₃ does not decompose, so that the semiconductor film doped with PrBr₃ may be obtained.

In a case where Tbl₃ is selected as the rare earth compound, and SnO₂ is selected as the semiconductor base material, Tbl₃ and SnO₂ may be dissolved in solvent to obtain a suspension, and a mole proportion of Tbl₃ and SnO₂ may be adjusted; and then a semiconductor film may be obtained by spin coating, annealing and other processes. During the annealing process, Tbl₃ does not decompose, so that the semiconductor film 100 doped with Tbl₃ may be obtained.

Here, it will be noted that, in the case where there is one kind of rare earth compound, M_{FD} may an element selected from cerium, praseodymium, neodymium, promethium, samarium, terbium and dysprosium, and A may be an element selected from bromine and iodine. For example, the rare earth compound may be PrBr₃. In the case where there are a plurality of kinds of rare earth compounds, M_{FD} may be one or more elements selected from cerium, praseodymium, neodymium, promethium, samarium, terbium and dysprosium, A may be one or more elements selected from one or more of bromine and iodine. For example, the at least one kind of rare earth compound may include PrBr₃ and Tbl₃.

In a step S202, the semiconductor film 100 is patterned to obtain an active layer 12 of the TFT 1.

The semiconductor film 100 may be patterned by exposure, development and etching processes after coating the semiconductor film 100 with a photoresist 200.

After the active layer 12 is formed, the method may further include a step S203. In S203, a source 15 and a drain 16 are formed on the base substrate 11 on which the active layer 12 has been formed. For example, a conductive film may be formed by evaporation or deposition, and then processes such as photoresist coating, exposure, development and etching may be performed on the conductive film to form the source 15 and the drain 16. Thicknesses of the source 15 and the drain 16 may be from 100 nm to 1000 nm, inclusive.

Based on the above specific implementations, in order to objectively evaluate technical effects of the technical solutions provided in the present disclosure, detailed exemplary description of the technical solutions provided in the present disclosure will be given through application examples, comparative examples and experimental examples hereinafter.

### Application Example 1

Application Example 1 provides a TFT. A method for fabricating the TFT is as follows.

In a step 1), an aluminum neodymium alloy (Al:Nd) film with a thickness of 300 nm is formed on a base substrate 11 by sputtering, and then processes such as coating photoresist, exposing, developing are performed on the aluminum neodymium alloy film to form a gate 13.

The base substrate 11 may be glass including a buffer layer.

In a step 2), an insulating layer is formed by anodizing to obtain a gate oxide layer 14 (Al₂O₃:Nd, i.e., alumina neodymium) with a thickness of 200 nm.

In a step 3), a material of TbB₆ and a material of In₂O₃ are respectively prepared into two target materials, and the two target materials are mounted at different target positions, and then simultaneously sputtered on the base substrate 11 with the gate insulating layer 14 to form a film of (TbB₆)ₓ(In₂O₃)₁₋ₓ. Coating photoresist, exposing, developing and other steps are performed on the film to form an active layer 12.

An elemental composition of the active layer 12 is represented as (TbB₆)ₓ(In₂O₃)₁₋ₓ, where x is equal to or greater than 0.001 and less than or equal to 0.15. Parallel experiments with x being respectively equal to 0.001, 0.01, 0.05, 0.1 and 0.15 are performed.

In a step 4), a metal oxide film of indium tin oxide (ITO) with a thickness of 240 nm is formed on the base substrate 11 on which the active layer 12 has been formed, and then a patterning process is performed on the metal oxide film to form a source 15 and a drain 16.

In a step 5), the prepared TFTs 1 are annealed in the atmospheric environment at 300 °C for 1 hour to obtain TFTs with x being respectively equal to 0.001, 0.01, 0.05, 0.1 and 0.15.

### Experimental Example 1

Transfer characteristic curves of the TFTs in Application Example 1 and a TFT fabricated under same conditions in a case where x is equal to 0 are tested. The tests are performed under a NBIS condition where a light-emitting diode (LED) is used for white light irradiation and a gate bias voltage is -30 V.

After the tests are completed, threshold voltage drift amounts (ΔVₜₕ) per unit time of the TFTs in Application Example 1 and the TFT fabricated under the same conditions in the case where x is equal to 0 are calculated, and then current values and threshold voltages of corresponding regions are plugged into a formula of a saturation region of the transfer characteristic, so that electron mobilities may be calculated. The calculated results of the threshold voltage drift amounts (ΔVₜₕ) and the electron mobilities are as shown in Table 3 below.

**Table 3**

| x | 0 | 0.001 | 0.01 | 0.05 | 0.1 | 0.15 |
|---|---|---|---|---|---|---|
| Electron mobility (cm²/Vs) | 25.8 | 24.7 | 22.6 | 20.1 | 11.2 | 5.6 |
| ΔVₜₕ (V/hour) | -17.3 | -11.6 | -2.8 | -0.8 | -1.7 | -2.9 |

In Table 3, ΔVₜₕ represents a threshold voltage shift amount per hour. As seen from Table 3 that, in a case where x is equal to 0.001, ΔVₜₕ under NBIS may be greatly reduced; in a case where x is increased to 0.01, ΔVₜₕ may be controlled within 3 V, which basically meets application requirements; and in a case where x is equal to 0.05, ΔVₜₕ is smallest and equal to 0.8 V. Therefore, as a doping amount of TbB₆ increases, ΔVₜₕ under NBIS overall shows a decreasing trend. However, ΔVₜₕ under NBIS slightly increases in a case where x is greater than 0.05. This indicates that, a doping with TbB₆ at only a small amount may greatly reduce the threshold voltage drift amount; and as a doping amount continues to increase, a decrease in the threshold voltage drift amount is not obvious, and even shows a rebound trend. In addition, the electron mobility shows a gradually decreasing trend as a value of x increases gradually. It can be seen that, in a case where the value of x is equal to 0.05, not only may the electron mobility be kept high, but also stability of TFT under NBIS may be improved. Therefore, a problem that electron mobility and NBIS stability of a metal oxide semiconductor material in related art are mutually restricted is solved.

In addition, it is found from tests of electrical properties of the devices under the NBIS condition that, in a case where x is equal to 0, a carrier concentration in an active layer 12 thereof is very large, and a threshold voltage of the TFT 1 is negative to a relatively large extent, which make it difficult for the TFT 1 to be turned off; and a carrier concentration in an active layer 12 doped with TbB₆ decreases, which may adjust the threshold voltage of the TFT 1 towards a positive direction. This shows that, TbB₆ further plays a role in suppressing oxygen vacancies and reducing the carrier concentration, which may further improve the photostability of the metal oxide semiconductor TFTs through the doping with TbB₆.

### Application Example 2

Application Example 2 provides a TFT, and steps 1), 2) and 4) of a method for fabricating the TFT are basically same as the steps 1), 2) and 4) in Application Example 1, which will not be repeated here.

Differences are as follows. In a step 3), a target material including Pr₂S₃, In₂O₃ and ZnO is fixed on a target position, and a (Pr₂S₃)ₓ(In_{5.2}Zn_{1.0}O_{y})₁₋ₓ film is formed on a base substrate with an gate insulating layer by using a single-target sputtering method; annealing is performed on the film at 250 °C for 1 h after sputtering; and then, coating photoresist, exposure, developing and other steps are performed on the film to form an active layer 12. Here, x is equal to 0.09, and y may be 8.8 or 9.

After a source 15 and a drain 16 are formed, the method further includes a step 5). In the step 5), an Al₂O₃ layer is formed as a passivation layer.

Before the (Pr₂S₃)ₓ(In_{5.2}Zn_{1.0}O_{y})₁₋ₓ film with the thickness of 20 nm is formed on the base substrate 11 with the gate insulating layer 14 by using the single-target sputtering method, the method may further include: uniformly blending a nanomaterial of Pr₂S₃, a nanomaterial of In₂O₃ and a nanomaterial of ZnO together according to corresponding proportions, and forming the target material including Pr₂S₃, In₂O₃ and ZnO by ball milling, slurry casting, sintering and other processes.

### Comparative Example

A method for fabricating a TFT in Comparative Example is basically same as the method for fabricating the TFT in Application Example 2. A difference is that, in Comparative Example, an active layer 12 is doped with Pr₂O₃. That is, an elemental composition of the active layer 12 is represented as (Pr₂C₃)ₓ(In_{5.2}Zn_{1.0}O_{y})₁₋ₓ, where x and y are same as that in Application Example 2.

### Experimental Example 2

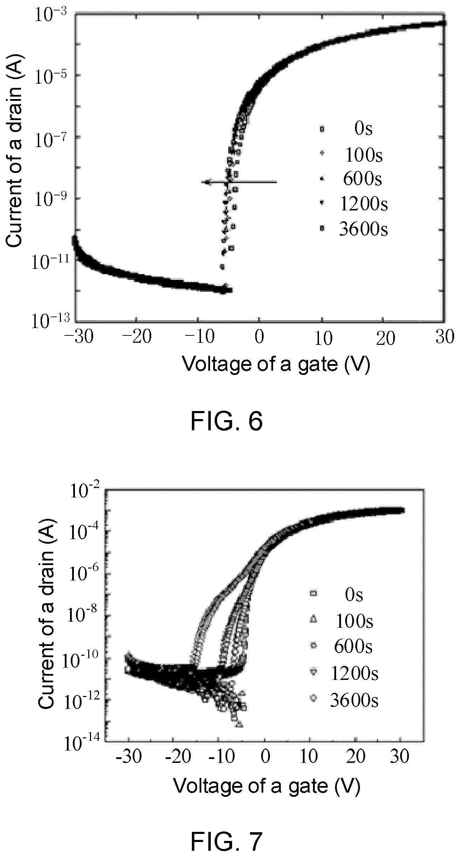

The TFTs in Application Example 2 and Comparative Example are tested to obtain transfer characteristic curves thereof. The tests are performed under the NBIS condition where the LED is used for white light irradiation and the gate bias voltage is - 30 V. The tests are at 0th seconds, 100th seconds, 600th seconds, 1200th seconds and 3600th seconds after a time when the gate bias voltage is applied. Test results are as shown in FIGS. 6 and 7.

It can be seen from a comparison of FIGS. 6 and 7 that, a threshold voltage shift amount (ΔVₜₕ) of the TFT doped with Pr₂O₃ under NBIS is 9.2 V/h, and a mobility thereof is calculated to be 22.1 cm²/Vs; and a threshold voltage shift amount (ΔVₜₕ) of the TFT doped with Pr₂S₃ under NBIS is 1.4 V/h, and a mobility thereof is up to 34.2 cm²/Vs.

It may be concluded from this that, the TFT doped with Pr₂S₃ has a higher mobility and a more distinct and better NBIS stability than the TFT doped with Pr₂S₃.

### Experimental Example 3

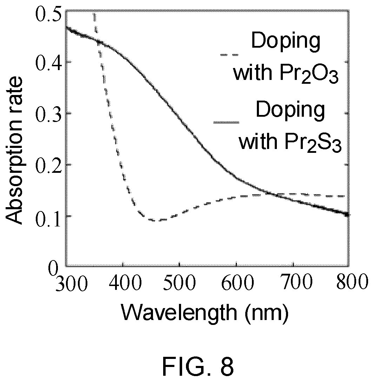

A semiconductor film doped with Pr₂S₃ that is formed in Application Example 2 and a semiconductor film doped with Pr₂O₃ that is formed in Comparative Example are tested to obtain absorption spectrums. FIG. 8 is a comparison diagram of the absorption spectrums of the semiconductor film doped with Pr₂S₃ and the semiconductor film doped with Pr₂O₃.

It can be seen from FIG. 8 that, an absorption edge of the absorption spectrum of the semiconductor film doped with Pr₂O₃ is around 430 nm, while an absorption edge of the absorption spectrum of the semiconductor film doped with Pr₂S₃ is greatly shifted towards red light to between 500 nm and 600 nm. This indicates that, a combination an anion of S and Pr has a nephelauxetic effect, which may effectively stretch an absorption spectrum of f-d transition towards red light to a region of blue light or even a region of green light, thereby greatly improving the NBIS stability.

Here, it can be noted that, since E_{fd} of a trivalent ion of Pr is similar to E_{fd} of a trivalent ion of Tb, a semiconductor film with Pr and a semiconductor film with Tb are same in a changing trend of a threshold voltage shift amount versus a value of x and a changing trend of an electron mobility versus the value of x under respective NBIS and a same anion environment.

### Application Example 3

Application Example 3 provides a TFT, and steps 1) and 2) for a method for fabricating the TFT are basically same as the steps 1) and 2) in Application Example 1, which will not be repeated here.

A difference is that, in a step 3), an active layer 12 is formed by a solution method, and after the active layer 12 is formed, an aluminum film is formed by evaporation deposition, and then a patterning process is performed on the aluminum film to form a source 15 and a drain 16.

Here, a semiconductor base material is doped with each of three different kinds of rare earth compounds (e.g., NdBr₃, PrBr₃ and PrCl₃) separately to fabricate three groups of TFTs doped with the three different kinds of rare earth compounds (e.g., NdBr₃, PrBr₃ and PrCl₃) for comparison. For the three groups of TFTs, mole proportions x of rare earth compounds in rare earth compounds and In₂O₃ are all same.

Here, considering an example where the rare earth compound is NdBr₃, a method of forming the active layer 12 by the solution method includes the following steps.

In (1), a solution of NdBr₃ and In(NO₃)₃ is prepared.

Considering a total molarity of the solution as 0.2 mol/L, masses of NdBr₃ and In(NO₃)₃ are calculated according to a mole proportion x of NdBr₃ in NdBr₃ and In₂O₃, and then NdBr₃ and In(NO₃)₃ of the masses are obtained; NdBr₃ and In(NO₃)₃ of the masses are dissolved by using deionized water as solvent; and stirred for 12 h. Then, the solution of NdBr₃ and In(NO₃)₃ is obtained.

In (2), the solution of NdBr₃ and In(NO₃)₃ is formed on a base substrate 11 by a spin-coating process, on which a gate 13 and a gate insulating layer 14 have been formed. The spin-coating process is divided into two stages. In a first stage, spin-coating is performed at a low speed. The spin coating may be performed at 500 rpm for 3 s. In a second stage, the spin coating is performed at a high speed. The spin coating may be performed at 5000 rpm for 40s.

In (3), a pre-bake is performed on the solution first at 40 °C for 20 min, heated to 90 °C, and then baked for 10 min to remove the solvent; ultraviolet (UV) irradiation is performed for 30 min by means of a mask, and then etching with solvent is performed to achieve patterning; and finally high temperature annealing (baking at 250 °C for 1 h) is performed to form an active layer 12.

### Experimental Example 4

The TFTs obtained in Application Example 3 are tested to obtain transfer characteristic curves. The tests are performed under the NBIS condition where the LED is used for white light irradiation and the gate bias voltage is -30 V.

After the tests are completed, threshold voltage drift amounts (ΔVₜₕ) per unit time of the TFTs in Application Example 3 under the NBIS condition are calculated. Calculation results are as shown in Table 4 below.

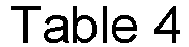

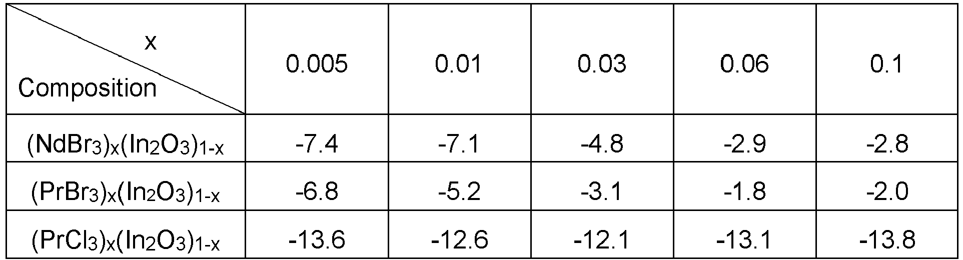

As seen from Table 4 that, under a same anion environment, a TFT 1 with Pr as cations has a NBIS stability better than a TFT 1 with Nd as cations; and under a same cation environment, a TFT 1 with Br as anions has a better NBIS stability than a TFT 1 with Cl as anions. This is consistent with the previous analyses regarding E_{fd} of cations and electronegativity of anions.

Here, it will be noted that, since the electron mobility of the TFT is also related to a fabrication method, electron mobilities of TFTs fabricated by solution method (forming active layers thereof) are generally less than electron mobilities of TFTs fabricated by deposition (forming active layers thereof). A value of electron mobility of a TFT will not be described here. In practical applications, those skilled in the art may select an appropriate fabrication method according to needs.

In summary, by doping the semiconductor base material with the rare earth compound at a small amount and selecting anions in the rare earth compound, the threshold voltage shift amount under NBS may be greatly reduced, the photostability of the TFT under NBIS may be improved, and the electron mobility may be kept high, which solves the problem that the electron mobility and the NBIS stability of the metal oxide semiconductor material in the related art mutually restrict each other. It is found through experiments that, by adjusting the doping ratio in the rare earth compound, the threshold voltage shift amount of the TFT under illumination and the gate bias stress of -30 V may be controlled to be less than 3 V per hour, and even the threshold voltage shift amounts of most TFTs under illumination and the gate bias stress of -30 V may reach less than 2 V per hour, which achieves a good application effect.

The foregoing descriptions are merely specific implementations of the present disclosure. However, the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A metal oxide semiconductor material, comprising:
a semiconductor base material; and
at least one kind of rare earth compound doped in the semiconductor base material, each kind of rare earth compound having a general formula represented as (M_{FD})ₐA_{b}, wherein
in the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}.

2. The metal oxide semiconductor material according to claim **1**, wherein
in the general formula (M_{FD})ₐA_{b}, M_{FD} is an element selected from lanthanide metal elements other than lanthanum.

3. The metal oxide semiconductor material according to claim **2,** wherein
in the general formula (M_{FD})ₐA_{b}, M_{FD} is an element selected from cerium, praseodymium, neodymium, promethium, samarium, terbium and dysprosium.

4. The metal oxide semiconductor material according to claim **2,** wherein
in the general formula (M_{FD})ₐA_{b}, M_{FD} is an element selected from praseodymium and terbium.

5. The metal oxide semiconductor material according to any one of claims **1** to **4,** wherein
in the general formula (M_{FD})ₐA_{b}, A is an element selected from elements whose electronegativities are less than an electronegativity of oxygen.

6. The metal oxide semiconductor material according to claim **5,** wherein
in the general formula (M_{FD})ₐA_{b}, A is an element selected from sulfur, selenium, tellurium, bromine, iodine, arsenic and boron.

7. The metal oxide semiconductor material according to any one of claims **1** to **6**, wherein
in each kind of rare earth compound comprised in the metal oxide semiconductor material, a minimum energy required for the element M_{FD} to undergo the f-d transition is less than 2.64 eV.

8. The metal oxide semiconductor material according to claim **7**, wherein
in each kind of rare earth compound comprised in the metal oxide semiconductor material, the minimum energy required for the element M_{FD} to undergo the f-d transition is greater than 2.48 eV.

9. The metal oxide semiconductor material according to any one of claims **1** to **8**, wherein
the semiconductor base material includes at least one kind of first metal oxide and/or at least one kind of second metal oxide, and each kind of first metal oxide and each kind of second metal oxide both have a general formula M_{c}O_{d}, wherein
for each kind of first metal oxide, M in the general formula M_{c}O_{d} is an element selected from indium, zinc, gallium, tin and cadmium;
for each kind of second metal oxides, M in the general formula M_{c}O_{d} is a combination of two or more elements selected from indium, zinc, gallium, tin and cadmium; and
c is a number of M in the general formula M_{c}O_{d}, and d is a number of oxygens in the general formula.

10. The metal oxide semiconductor material according to claim **9**, wherein
in the general formula M_{c}O_{d}, M further includes an element or a combination of any two or more elements of lanthanide metals, scandium and yttrium.

11. The metal oxide semiconductor material according to any one of claims **1** to **10**, wherein
in the metal oxide semiconductor material, an elemental composition of the semiconductor base material and the at least one kind of rare earth compound is represented as ((M_{FD})ₐA_{b})_{X}(M_{c}O_{d})_{1-X}, wherein x is greater than or equal to 0.001 and less than or equal to 0.15.

12. The metal oxide semiconductor material according to claim **11**, wherein
in the general formula (M_{FD})ₐA_{b}, in a case where M_{FD} is an element selected from praseodymium and terbium, x is greater than or equal to 0.01 and less than or equal to 0.1.

13. The metal oxide semiconductor material according to claim **11**, wherein
in the general formula (M_{FD})ₐA_{b}, in a case where cerium is selected as M_{FD}, x is greater than or equal to 0.001 and less than or equal to 0.02.

14. A target material comprising the metal oxide semiconductor material according to any one of claims **1** to **13**.

15. The target material according to claim **14**, wherein
in the general formula (M_{FD})ₐA_{b} of the metal oxide semiconductor material, A is an element selected from sulfur, selenium, tellurium, arsenic and boron.

16. A thin film transistor, comprising:
an active layer, a material of the active layer including the metal oxide semiconductor material according to any one of claims **1** to **13**.

17. A method for fabricating a target material, comprising:
doping a semiconductor base material with at least one kind of rare earth compound in proportion, and mixing the semiconductor base material and the at least one kind of rare earth compound evenly, a general formula of each kind of rare earth compound being represented as (M_{FD})ₐA_{b}, wherein in the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}; and
performing ball milling, hot pressing or slurry casting, and then sintering on the evenly mixed semiconductor base material doped with the at least one kind of rare earth compound to obtain the target material.

18. The method for fabricating the target material according to claim **17**, wherein,
in the general formula (M_{FD})ₐA_{b}, A is an element selected from sulfur, selenium, tellurium, arsenic and boron.

19. A method for fabricating a thin film transistor, comprising:
forming a semiconductor film on a base substrate, a material of the semiconductor film including a semiconductor base material and at least one kind of rare earth compound doped in the semiconductor base material, a general formula of each kind of rare earth compound being represented as (M_{FD})ₐA_{b}, wherein in the general formula (M_{FD})ₐA_{b}, M_{FD} is an element selected from rare earth elements capable of undergoing f-d transition and/or charge transfer transition, A is selected from elements capable of stretching a wavelength range of an absorption spectrum of M_{FD} capable of undergoing the f-d transition and/or the charge transfer transition towards red light into a visible light range, a is a number of the element M_{FD} in the general formula (M_{FD})ₐA_{b}, and b is a number of the element A in the general formula (M_{FD})ₐA_{b}; and
patterning the semiconductor film to obtain an active layer of the thin film transistor.

20. The method for fabricating the thin film transistor according to claim **19**, wherein in a case where in the at least one kind of rare earth compound, A is one or more elements selected from sulfur, selenium, tellurium, arsenic and boron, forming the semiconductor film on the base substrate, includes:
providing a target material including a metal oxide semiconductor material; and
forming the semiconductor film on the base substrate by a sputtering process;
or
providing target materials including the at least one kind of rare earth compound and the semiconductor base material respectively; and
forming the semiconductor film on the base substrate by a double-target sputtering process.

21. The method for fabricating the thin film transistor according to claim **19**, wherein
in a case where in the at least one kind of rare earth compound, A is one or both of bromine and iodine, forming the semiconductor film on the base substrate, includes:
forming the semiconductor film on the base substrate by a solution method.

22. The method for fabricating the thin film transistor according to claim **21**, wherein
the solution method includes one of spin coating, ink jet printing, screen printing, scrape coating and imprinting.
